# EUROPÄISCHE PATENTSCHRIFT

(11) **EP 1 079 476 B1**
(45) Veröffentlichungstag und Bekanntmachung des Hinweises auf die Patenterteilung: **03.05.2006**
(21) Anmeldenummer: 00117832.6
(22) Anmeldetag: 18.08.2000
(51) Int. Cl.: H01R 13/658, H01R 43/02

(54) **Zur Montage auf eine Leiterplatte ausgelegtes Bauteil**
Method of mounting an electric part on a circuit board
Méthode de montage d'un élément électrique sur un circuit imprimé

(30) Priorität: 20.08.1999 DE 19939582
(43) Veröffentlichungstag der Anmeldung: 28.02.2001
(73) Patentinhaber: TYCO Electronics Logistics AG, 9323 Steinach (CH)
(72) Erfinder: Vanbesien, Johan, 8902 Ieper (BE)
(74) Vertreter: Hirsch, Peter

(56) Entgegenhaltungen:
- EP-A- 0 821 447
- EP-A- 0 918 378
- US-A- 5 161 999
- US-A- 5 295 867

## Beschreibung

Die vorliegende Erfindung betrifft eine Vorrichtung gemäß dem Oberbegriff des Patentanspruchs 1, d.h. ein zur Montage auf eine Leiterplatte ausgelegtes Bauteil, mit einer Vielzahl von mit der Leiterplatte zu verlötenden elektrischen Anschlußelementen, und mit einer zumindest die elektrischen Anschlußelemente umgebenden Abschirmeinrichtung.

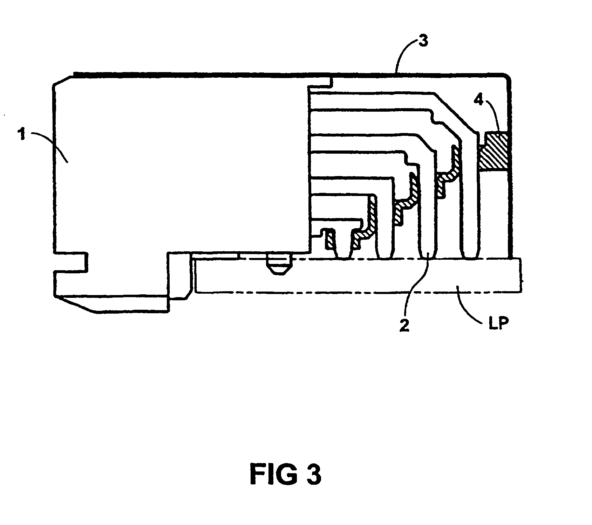

Ein solches Bauteil ist beispielsweise der in Figur 3 gezeigte elektrische Verbinder. Der gezeigte elektrische Verbinder besteht im wesentlichen aus in der Figur 3 nicht gezeigten Kontaktelementen zum Verbinden des elektrischen Verbinders mit einem anderen elektrischen Verbinder, einem die Kontaktelemente umgebenden Gehäuse 1, aus dem Gehäuse 1 herausgeführten elektrischen Anschlußelementen 2 zum Verlöten des elektrischen Verbinders mit einer Leiterplatte LP, und einer Abschirmeinrichtung 3, welche das Gehäuse 1 und die elektrischen Anschlußelemente umgibt.

Die Abschirmeinrichtung ist ein üblicherweise aus Metall oder Metall enthaltendem Material bestehender Körper, der die abzuschirmenden Bereiche des Bauteils seitlich und oben umgibt und damit einerseits das Einstrahlen von elektromagnetischer Strahlung in den elektrischen Verbinder, und andererseits das Abstrahlen von elektromagnetischer Strahlung aus dem Verbinder verhindert oder einschränkt.

Elektrische Verbinder mit wie beschrieben oder anders ausgebildeten Abschirmeinrichtungen werden zunehmend häufiger benötigt.

Um solche Verbinder oder sonstige Abschirmeinrichtungen aufweisende Bauteile schnell und einfach auf Leiterplatten montieren zu können, bildet man sie nach Möglichkeit als eine zusammenhängende Einheit aus, verbindet also die Abschirmeinrichtung fest mit dem Gehäuse oder sonstigen Bestandteilen des betreffenden Bauteils.

Dies ist jedoch nicht immer ganz problemlos durchführbar. Es muß nämlich darauf geachtet werden, daß die Abschirmeinrichtung im auf die Leiterplatte montierten Zustand des Bauteils möglichst exakt mit der Leiterplattenoberfläche abschließt. Bleibt zwischen der Leiterplatte und der Abschirmeinrichtung ein Spalt, so verschlechtert dies die Abschirmwirkung. Ragt die Abschirmeinrichtung hingegen zu weit nach unten, kann das Bauteil nicht mehr ordnungsgemäß auf die Leiterplatte aufgesetzt werden und/oder wird das ordnungsgemäße Verlöten der elektrischen Anschlußelemente mit der Leiterplatte erschwert oder gänzlich unmöglich. Letzteres gilt insbesondere, wenn es sich bei dem betreffenden Bauteil um ein oberfächenmontierbares Bauteil (SMT-Bauteil) handelt. Wenn bei einem solchen Bauteil die Abschirmeinrichtung auch nur teilweise geringfügig zu weit nach unten ragt, so können die elektrischen Anschlußelemente entweder überhaupt nicht oder nur mangelhaft mit der Leiterplatte verlötet werden.

Die Herstellung, der Zusammenbau und/oder die Handhabung von mit Abschirmeinrichtungen versehenen Bauteilen erfordern daher höchste Präzision. Dies ist verständlicherweise ein erheblicher Nachteil.

Der vorliegenden Erfindung liegt daher die Aufgabe zugrunde, das Bauteil gemäß dem Oberbegriff des Patentanspruchs 1 derart weiterzubilden, daß die Abschirmeinrichtung die Montage des betreffenden Bauteils auf die Leiterplatte nicht beeinträchtigen kann.

Diese Aufgabe wird erfindungsgemäß durch das im kennzeichnenden Teil des Patentanspruchs 1 beanspruchte Merkmal gelöst.

Demnach ist vorgesehen, daß die Abschirmeinrichtung und die elektrischen Anschlußelemente relativ zueinander bewegbar sind.

Dadurch kann unter allen Umständen gewährleistet werden, daß die Abschirmeinrichtung
- der bestimmungsgemäßen Montage des Bauteils auf die Leiterplatte nicht im Wege steht, und
- dennoch die unter den gegebenen Umständen optimale Abschirmwirkung entfaltet.

Ein wie beansprucht ausgebildetes Bauteil kann einerseits unter allen Umständen schnell und sicher ordnungsgemäß auf die Leiterplatte montiert werden, und ist andererseits im auf die Leiterplatte montierten Zustand optimal abgeschirmt.

Vorteilhafte Weiterbildungen der Erfindung sind den Unteransprüchen, der nachfolgenden Beschreibung und den Figuren entnehmbar.

Die Erfindung wird nachfolgend anhand von Ausführungsbeispielen unter Bezugnahme auf die Figuren näher erläutert. Es zeigen
- Figur 1: einen eine Abschirmeinrichtung aufweisenden elektrischen Verbinder im an dessen Gehäuse gehaltenen Zustand,
- Figur 2: den in Figur 1 gezeigten elektrischen Verbinder im an dessen Abschirmeinrichtung gehaltenen Zustand, und
- Figur 3: einen eine Abschirmeinrichtung aufweisenden elektrischen Verbinder, bei welchem die Abschirmeinrichtung und das Verbindergehäuse starr miteinander verbunden sind.

Bei dem Bauteil, anhand dessen die Erfindung nachfolgend näher beschrieben wird, handelt es sich um einen zur Montage auf eine Leiterplatte ausgelegten elektrischen Verbinder. Es sei jedoch bereits an dieser Stelle darauf hingewiesen, daß die nachfolgend näher beschriebenen Besonderheiten des elektrischen Verbinders auch bei anderen zur Montage auf eine Leiterplatte ausgelegten Bauteilen, die mit einer Abschirmeinrichtung versehen sind, vorgesehen werden können.

Der vorliegend näher betrachtete elektrische Verbinder weist eine Vielzahl von mit der Leiterplatte zu verlötenden elektrischen Anschlußelementen, und eine zumindest die elektrischen Anschlußelemente umgebende Abschirmeinrichtung auf.

Bei den mit der Leiterplatte zu verlötenden elektrischen Anschlußelementen handelt es sich im betrachteten Beispiel um zur Oberflächenmontage des Bauteils auf die Leiterplatte ausgelegte SMT-Kontakte. Die mit der Leiterplatte zu verlötenden elektrischen Anschlußelemente können aber auch zum Verlöten (Reflow-Löten, Wellenlöten etc.) in durchkontaktierten Löchern der Leiterplatte ausgebildete Anschlußelemente sein. Ebenso wäre denkbar, daß die mit der Leiterplatte zu verlötenden elektrischen Anschlußelemente des Bauteils zum Verlöten derselben auf der gegenüberliegenden Seite der Leiterplatte ausgebildete Anschlußelemente sind.

Es sei bereits an dieser Stelle darauf hingewiesen, daß sich das Vorsehen der nachfolgend näher beschriebenen Besonderheiten bei Bauteilen, bei welchen die elektrischen Anschlußelemente durch SMT-Kontakte gebildet werden, besonders vorteilhaft auswirkt; positive Effekte lassen sich aber grundsätzlich bei allen Bauteilen erzielen, die mit der Leiterplatte zu verlötende Anschlußelemente aufweisen, und zwar unabhängig davon, wo und wie das Verlöten erfolgt.

Der vorliegend näher betrachtete elektrische Verbinder entspricht insoweit dem eingangs unter Bezugnahme auf die Figur 3 beschriebenen elektrischen Verbinder.

Der Vollständigkeit halber sei angemerkt, daß des sich bei dem betrachteten elektrischen Verbinder um einen Steckverbinder handelt, der durch einen gemäß der Darstellung in der Figur 3 von links eingesteckten Gegenverbinder kontaktiert werden kann.

Der vorliegend näher betrachtete Verbinder zeichnet sich dadurch aus, daß die Abschirmeinrichtung und die elektrischen Anschlußelemente relativ zueinander bewegbar sind.

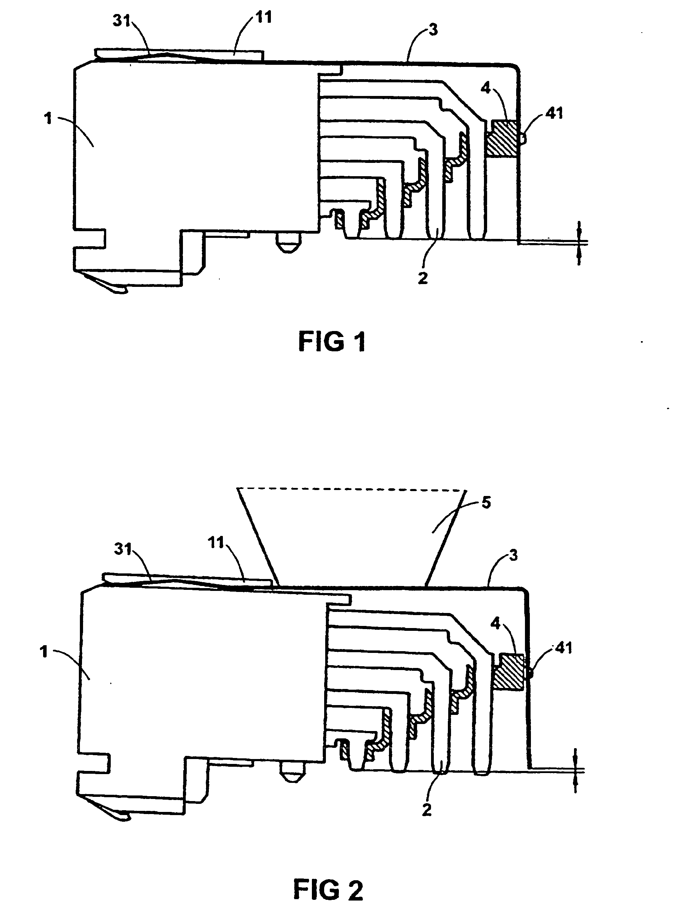

Dies wird nachfolgend unter Bezugnahme auf die Figuren 1 und 2 näher beschrieben.

Die Figur 1 zeigt den vorliegend betrachteten elektrischen Verbinder im an dessen Gehäuse gehaltenen Zustand, und die Figur 2 zeigt den vorliegend betrachteten elektrischen Verbinder im an dessen Abschirmeinrichtung gehaltenen Zustand.

Dabei sind das Gehäuse des elektrischen Verbinders wiederum mit dem Bezugszeichen 1, die aus dem Gehäuse herausgeführten elektrischen Anschlußelemente mit dem Bezugszeichen 2, und die Abschirmeinrichtung mit dem Bezugszeichen 3 bezeichnet.

Die elektrischen Anschlußelemente 2 sind durch eine Ausrichtplatte 4 hindurchgeführt und werden durch diese in einer vorbestimmten Relativlage gehalten. Bezüglich weiterer Einzelheiten zu einer derartigen Ausrichtplatte wird auf die DE 197 54 877 A1 verwiesen.

Die Abschirmeinrichtung 3 ist im betrachteten Beispiel ein aus Metall oder aus Metall enthaltendem Material bestehendes Übergehäuse, welches die abzuschirmenden Bereiche des Bauteils (im betrachteten Beispiel das Gehäuse 1 und die elektrischen Anschlußelemente 2) seitlich und oben umgibt und im auf die Leiterplatte montierten Zustand des elektrischen Verbinders auf der Leiterplatte aufsitzt.

Die Abschirmeinrichtung 3 ist mit den restlichen Bestandteilen des elektrischen Verbinders so verbunden, daß der elektrische Verbinder einschließlich der Abschirmeinrichtung eine zusammenhängende Einheit bildet und als solche auf die Leiterplatte montierbar ist.

Die Abschirmeinrichtung 3 ist derart ausgebildet und/oder derart mit den restlichen Bestandteilen des elektrischen Verbinders verbunden, daß die Abschirmeinrichtung 3 relativ zum Gehäuse 1 und - noch wichtiger - relativ zu den elektrischen Anschlußelementen 2 bewegbar ist.

Im betrachteten Beispiel ist die Abschirmeinrichtung 3 an zwei Stellen mit den restlichen Bestandteilen des elektrischen Verbinders verbunden, nämlich am Gehäuse 1 und an der Ausrichtplatte 4.

Die Befestigung der Abschirmeinrichtung 3 am Gehäuse 1 erfolgt dadurch, daß die Abschirmeinrichtung zwischen dem Gehäuse 1 und zwei an dessen Oberseite vorgesehenen, elastisch federnd ausgebildeten Zungen 11 gehalten wird. Die Zungen 11 sind im betrachteten Beispiel an ihrem gemäß der Darstellung in den Figuren 1 und 2 linken Ende mit dem Gehäuse 1 verbunden und erstrecken sich von dort parallel zueinander verlaufend nach rechts. Die Abschirmeinrichtung 3 ist (von gemäß der Darstellung in den Figuren 1 und 2 rechten Seite her) zwischen die Oberseite des Gehäuses 1 und die Zungen 11 einschiebbar und wird im bestimmungsgemäß am Gehäuse 1 angeordneten Zustand zwischen der Oberseite des Gehäuses 1 und den Zungen 11 eingeklemmt.

Die Verbindung der Abschirmeinrichtung 3 und der Ausrichtplatte 4 ist ein lose Verbindung, durch welche im betrachteten Beispiel "nur" die Richtung der möglichen Relativbewegung von Abschirmeinrichtung 3 und den restlichen Verbinderbestandteilen festgelegt wird und der Umfang der möglichen Relativbewegung von Abschirmeinrichtung 3 und den restlichen Verbinderbestandteilen begrenzt wird. Die Verbindung zwischen der Abschirmeinrichtung 3 und der Ausrichtplatte 4 erfolgt im betrachteten Beispiel dadurch, daß eine in einer Seitenwand (in betrachteten Beispiel eine in der hinteren Seitenwand) der Abschirmeinrichtung 3 vorgesehene Öffnung auf einen an der Ausrichtplatte 4 vorgesehenen Stift 41 aufgesetzt wird. Die (in der Figur nicht gezeigte) Öffnung in der Abschirmeinrichtung 3 und der Stift 41 sind so bemessen, daß sich die Öffnung und der diese enthaltende Teil der Abschirmeinrichtung quer zum Stift 41 bewegen kann. Die Öffnung in der Abschirmeinrichtung ist vorzugsweise ein sich in vertikaler Richtung erstreckendes Langloch; dadurch kann die Abschirmeinrichtung nach Art eines klappbaren Deckels in einem gewissen Umfang auf- und abgeschwenkt werden.

Dies ist in den Figuren 1 und 2 veranschaulicht.

Die Figur 1 zeigt den elektrischen Verbinder in einem am Gehäuse 1 gehaltenen Zustand, und die Figur 2 zeigt den elektrischen Verbinder in einem an der Abschirmeinrichtung 3 gehaltenen Zustand. Das Halten des elektrischen Verbinders in dem in der Figur 2 gezeigten Zustand, d.h. das Halten des elektrischen Verbinders an der Abschirmeinrichtung 3 erfolgt im betrachteten Beispiel durch eine Vakuumpipette 5. Solche Vakuumpipetten werden auch beim Bestücken von Leiterplatten mit den darauf unterzubringenden Bauteilen verwendet; die Vakuumpipette nimmt die auf die Leiterplatte zu montierenden Bauteile wie in der Figur 2 gezeigt auf und setzt sie an der ihnen zugeordneten Stelle auf die Leiterplatte ab.

Wie aus einer Gegenüberstellung der Figuren 1 und 2 ersichtlich ist, befindet sich bei dem in der Figur 1 dargestellten Zustand des elektrischen Verbinders das untere Ende der vom Gehäuse 1 abgewandten Seite der Abschirmeinrichtung 3 auf einem niedrigeren Niveau als die freien Enden (die mit der Leiterplatte zu verlötenden Teile) der elektrischen Anschlußelemente 2, wohingegen sich bei dem in der Figur 2 dargestellten Zustand des elektrischen Verbinders das untere Ende der vom Gehäuse 1 abgewandten Seite der Abschirmeinrichtung 3 auf einem höheren Niveau befindet als die freien Enden (die mit der Leiterplatte zu verlötenden Teile) der elektrischen Anschlußelemente 2.

Wenn die Vakuumpipette 5 den elektrischen Verbinder an der Abschirmeinrichtung 3 hält und auf die Leiterplatte aufsetzt, können die miteinander zu verlötenden Teile der elektrischen Anschlußelemente 2 und der Leiterplatte bestimmungsgemäß zusammengebracht werden; die Abschirmeinrichtung 3 kann diesem Vorgang nicht im Wege stehen. Wenn die Vakuumpipette 5 das Bauteil, genauer gesagt dessen Abschirmeinrichtung 3 losläßt, senkt sich die Abschirmeinrichtung auf die Leiterplatte ab. Die Abschirmeinrichtung 3 liegt dann im wesentlichen zwischenraumfrei auf der Leiterplatte auf und entfaltet dadurch eine optimale Abschirmwirkung.

Die wie beschrieben oder ähnliche Ausbildung und Anbringung der Abschrirmeinrichtung 3 erweist sich als enormer Vorteil: dadurch ist unter allen Umständen gewährleistet, daß
- das mit der Abschirmeinrichtung eine zusammenhängende Einheit bildende Bauteil schnell, einfach und sicher bestimmungsgemäß auf die Leiterplatte montierbar ist, und
- die Abschirmeinrichtung eine optimale Abschirmwirkung entfaltet.

Die die Verbindung zwischen dem Gehäuse 1 und der Abschirmeinrichtung 3 bewirkenden Zungen 11 haben im betrachteten Beispiel eine Doppelfunktion: sie dienen zugleich als Codierelemente des elektrischen Verbinders, welche verhindern, daß der elektrischen Verbinder mit elektrischen Verbindern verbunden wird, mit denen er nicht verbunden werden darf, und/oder daß der elektrische Verbinder falsch orientiert mit einem anderen Verbinder verbunden wird.

Die Abschirmeinrichtung 3 hat im betrachteten Beispiel ebenfalls eine Doppelfunktion. Sie weist in dem entlang der Gehäuseoberseite verlaufenden Bereich (vorzugsweise zwischen und neben den Zungen 11) als Kontaktelemente verwendbare Wölbungen 31 auf; diese Wölbungen 31 können mit zugeordneten Kontaktelementen des mit dem elektrischen Verbinder in Kontakt zu bringenden Gegenverbinder in Kontakt kommen.

Es dürfte einleuchten, daß der beschriebene elektrische Verbinder mannigfaltig modifizierbar ist.

Unter anderem besteht selbstverständlich keine Einschränkung darauf, daß zwei Zungen 11 vorgesehen ist. Es kann auch eine beliebige andere Anzahl von Zungen 11 vorgesehen sein. Es besteht ferner keine Einschränkung darauf, daß die Zungen an einer ganz bestimmten Stelle mit dem Gehäuse verbunden sind und/oder in eine ganz bestimmte Richtung verlaufen.

Die Verbindung zwischen der Abschirmeinrichtung 3 und dem Gehäuse 1 kann natürlich auch anders als unter Verwendung von Zungen erfolgen. Daß für die beschriebene Verbindung zwischen der Abschirmeinrichtung 3 und dem Gehäuse 1 gleichwertige und vielleicht sogar bessere Alternativen existieren, dürfte einleuchten und bedarf keiner näheren Erläuterung. Es muß "nur" gewährleistet sein, daß die Abschirmeinrichtung im mit dem Gehäuse 1 verbundenen Zustand ohne Lösung dieser Verbindung zumindest geringfügig wie in den Figuren 1 und 2 veranschaulicht relativ zum Gehäuse 1 und den elektrischen Anschlußelementen 2 bewegbar ist.

Es besteht ferner keine Einschränkung darauf, daß die Abschirmeinrichtung 3 und die Zungen 11 die vorstehend erwähnten Doppelfunktionen haben.

Ferner kann vorgesehen werden, auch die Abschirmeinrichtung 3 mit der Leiterplatte LP zu verbinden. Bei oberflächenmontierbaren Bauteilen wie dem vorliegend betrachteten elektrischen Verbinder erfolgt diese Verbindung vorzugsweise ebenfalls unter Verwendung eines SMT-Verfahrens. Sie kann grundsätzlich aber auf beliebige Art und Weise erfolgen. Das Verlöten der elektrischen Anschlußelemente 2 mit der Leiterplatte und das Verlöten der Abschirmeinrichtung 3 mit der Leiterplatte können (abhängig von den individuellen Gegebenheiten) gleichzeitig oder nacheinander durchgeführt werden. Das Verlöten oder das sonstige Verbinden der Abschirmeinrichtung 3 mit der Leiterplatte erweist sich in zweifacher Hinsicht als vorteilhaft: einerseits kann die Abschirmeinrichtung über die Verbindung mit der Leiterplatte mit einem für die Abschirmung günstigen Potential (beispielsweise Massepotential) beaufschlagt werden, und andererseits kann sich die Abschirmeinrichtung danach nicht mehr bewegen. Zum letztgenannten Punkt ist anzumerken, daß der Wegfall der Bewegbarkeit der Abschirmeinrichtung keine Nachteile mit sich bringt. Schließlich ist die Montage des elektrischen Verbinders mit der Verbindung von Abschirmeinrichtung und Leiterplatte abgeschlossen; danach ist eine Bewegbarkeit der Abschirmeinrichtung eher störend als hilfreich. Aus den genannten Gründen sollte die Abschirmeinrichtung nach Möglichkeit mit der Leiterplatte verbunden werden. Zwingend erforderlich ist dies jedoch nicht.

Bei wie beschrieben ausgebildeten Bauteilen kann unabhängig von den Einzelheiten der praktischen Realisierung auf sehr einfache Weise gewährleistet werden, daß die Abschirmeinrichtungen die Montage des betreffenden Bauteile auf die Leiterplatte nicht beeinträchtigen können.

## Patentansprüche

1. Zur Montage auf eine Leiterplatte (LP) ausgelegtes Bauteil, mit einer Vielzahl von mit der Leiterplatte zu verlötenden elektrischen Anschlußelementen (2), und mit einer zumindest die elektrischen Anschlußelemente umgebenden Abschirmeinrichtung (3),
**dadurch gekennzeichnet,**
**daß**, bei der Montage auf die Leiterplatte, die Abschirmeinrichtung (3) und die elektrischen Anschlußelemente (2) durch mechamische Wechselwirdung zwischen der Abschirmeinrichtung und der Leiterplatte relativ zueinander bewegbar sind. zueinander bewegbar sind.

2. Bauteil nach Anspruch 1,
**dadurch gekennzeichnet,**
**daß** die Abschirmeinrichtung (3) ein separates Element ist, welches vor und/oder nach dem Verlöten der elektrischen Anschlußelemente (2) mit den restlichen Bestandteilen des elektrischen Verbinders verbindbar ist.

3. Bauteil nach Anspruch 1 oder 2,
**dadurch gekennzeichnet,**
**daß** die Abschirmeinrichtung (3) ein aus Metall oder aus Metall enthaltendem Material bestehender Körper ist, der die abzuschirmenden Bereiche des Bauteils seitlich und oben umgibt.

4. Bauteil nach einem der vorhergehenden Ansprüche
**dadurch gekennzeichnet,**
**daß** die Abschirmeinrichtung (3) und die restlichen Bestandteile des Bauteils eine zusammenhängende Einheit bilden oder durch Verbinden zu einer zusammenhängenden Einheit machbar sind.

5. Bauteil nach einem der vorhergehenden Ansprüche,
**dadurch gekennzeichnet,**
**daß** die Abschirmeinrichtung (3) durch ein Verklemmen an oder zwischen anderen Bestandteilen des Bauteils mit diesen verbindbar ist.

6. Bauteil nach einem der vorhergehenden Ansprüche,
**dadurch gekennzeichnet,**
**daß** die Abschirmeinrichtung (3) an einer ihrer Seitenwände eine Öffnung aufweist, die im mit den restlichen Bestandteilen des Bauteils verbundenen Zustand der Abschirmeinrichtung über einen an einem der anderen Bestandteile des Bauteils vorgesehenen Stift (41) aufgesetzt ist.

7. Bauteil nach Anspruch 6,
**dadurch gekennzeichnet,**
**daß** die Öffnung der Abschirmeinrichtung (3) ein sich in vertikale Richtung erstreckendes Langloch ist.

8. Bauteil nach einem der vorhergehenden Ansprüche,
**dadurch gekennzeichnet,**
**daß** die relative Bewegbarkeit von Abschirmeinrichtung (3) und elektrischen Anschlußelementen (2) im wesentlichen auf Richtungen begrenzt ist, längs welcher die Abschirmeinrichtung bei der Montage des Bauteils auf die Leiterplatte (LP) von den elektrischen Anschlußelementen wegbewegt werden können muß, um die Montage des Bauteils nicht zu behindern.

9. Bauteil nach einem der vorhergehenden Ansprüche,
**dadurch gekennzeichnet,**
**daß** die relative Bewegbarkeit von Abschirmeinrichtung (3) und elektrischen Anschlußelementen (2) ungefähr auf den Umfang begrenzt ist, um welchen die Abschirmeinrichtung bei der Montage des Bauteils auf die Leiterplatte (LP) von den elektrischen Anschlußelementen wegbewegt werden können muß, um die Montage des Bauteils nicht zu behindern.

10. Bauteil nach einem der vorhergehenden Ansprüche,
**dadurch gekennzeichnet,**
**daß** die Abschirmeinrichtung (3) derart ausgebildet und/oder derart mit den restlichen Bestandteilen des Bauteils verbunden ist, daß die mit der Leiterplatte (LP) zu verlötenden Stellen der elektrischen Anschlußelemente (2) im an der Abschirmeinrichtung gehaltenen Zustand des Bauteils tiefer liegen als der im auf die Leiterplatte montierten Zustand des Bauteils auf der Leiterplatte aufliegende Teil der Abschirmeinrichtung.

11. Bauteil nach einem der vorhergehenden Ansprüche,
**dadurch gekennzeichnet,**
**daß** die Abschirmeinrichtung (3) derart ausgebildet und/oder derart mit den restlichen Bestandteilen des Bauteils verbunden ist, daß die mit der Leiterplatte (LP) zu verlötenden Stellen der elektrischen Anschlußelemente (2) im an einem anderen Bestandteil als der Abschirmeinrichtung gehaltenen Zustand des Bauteils höher liegen als der im auf die Leiterplatte montierten Zustand des Bauteils auf der Leiterplatte aufliegende Teil der Abschirmeinrichtung.

12. Bauteil nach einem der vorhergehenden Ansprüche,
**dadurch gekennzeichnet,**
**daß** die Abschrimeinrichtung (3) mit der Leiterplatte (LP) verbunden wird.

## Claims

1. A component designed for mounting on a printed circuit board (LP), having a plurality of electrical terminal elements (2) for soldering to the printed circuit board and having a shielding means (3) surrounding at least the electrical terminal elements,
**characterised in that**, on mounting on the printed circuit board, the shielding means (3) and the electrical terminal elements (2) are movable relative to one another through mechanical interaction between the shielding means and the printed circuit board.

2. A component according to claim 1,
**characterised in that** the shielding means (3) is a separate element which may be connected to the remaining parts of the electrical connector before and/or after soldering of the electrical terminal elements (2).

3. A component according to claim 1 or claim 2,
**characterised in that** the shielding means (3) is a body consisting of metal or of metal-containing material, which surrounds the sides and top of the areas of the component to be shielded.

4. A component according to any one of the preceding claims,
**characterised in that** the shielding means (3) and the remaining parts of the component form a cohesive unit or may be connected together to form a cohesive unit.

5. A component according to any one of the preceding claims,
**characterised in that** the shielding means (3) may be connected with other parts of the component by being clamped to or between them.

6. A component according to any one of the preceding claims,
**characterised in that** the shielding means (3) comprises an opening in one of its side walls, which opening, when the shielding means is connected with the remaining parts of the component, is placed over a pin (41) provided on one of the other parts of the component.

7. A component according to claim 6,
**characterised in that** the opening in the shielding means (3) is a vertically extending slot.

8. A component according to any one of the preceding claims,
**characterised in that** the relative mobility of shielding means (3) and electrical terminal elements (2) is limited substantially to directions in which the shielding means has to be capable of being moved away from the electrical terminal elements on mounting of the component on the printed circuit board (LP) in order not to prevent mounting of the component.

9. A component according to any one of the preceding claims,
**characterised in that** the relative mobility of shielding means (3) and electrical terminal elements (2) is limited roughly to the amount by which the shielding means has to be capable of being moved away from the electrical terminal elements on mounting of the component on the printed circuit board (LP) in order not to prevent mounting of the component.

10. A component according to any one of the preceding claims,
**characterised in that** the shielding means (3) is so constructed and/or so connected with the remaining parts of the component that the points of the electrical terminal elements (2) to be soldered to the printed circuit board (LP) are lower, when the component is held by the shielding means, than the part of the shielding means resting on the printed circuit board when the component is mounted on the printed circuit board.

11. A component according to any one of the preceding claims,
**characterised in that** the shielding means (3) is so constructed and/or so connected with the remaining parts of the component that the points of the electrical terminal elements (2) to be soldered to the printed circuit board (LP) are higher, when the component is held by another part than the shielding means, than the part of the shielding means resting on the printed circuit board when the component is mounted on the printed circuit board.

12. A component according to any one of the preceding claims,
**characterised in that** the shielding means (3) is connected with the printed circuit board (LP).

## Revendications

1. Composant destiné à être monté sur une carte à circuit imprimé (LP), comportant plusieurs éléments de raccordement électriques (2) destinés à être soudés sur la carte à circuit imprimé, et un dispositif de blindage (3) entourant au moins les élément de raccordement électriques,
**caractérisé en ce que**
le dispositif de blindage (3) et les éléments de raccordement électriques (2) peuvent être déplaces mutuellement par suite d'une interaction entre le dispositif de blindage et la carte à circuit imprimé, lors du montage sur la carte à circuit imprimé.

2. Composant selon la revendication 1,
**caractérisé en ce que** le dispositif de blindage (3) est constitué par un élément séparé, pouvant être relié aux autres composants du connecteur électrique avant et/ou après le soudage des éléments de raccordement électriques (2).

3. Composant selon les revendications 1 ou 2,
**caractérisé en ce que** le dispositif de blindage (3) est constitué par un corps composé de métal ou d'un matériau contenant du métal, entourant latéralement et d'en haut les régions à protéger du composant.

4. Composant selon l'une des revendications précédentes,
**caractérisé en ce que** le dispositif de blindage (3) et les autres éléments du composant forment une unité cohérente ou peuvent former une unité cohérente par l'intermédiaire d'une liaison.

5. Composant selon l'une des revendications précédentes,
**caractérisé en ce que** le dispositif de blindage (3) peut être relié par serrage sur ou entre les autres éléments du composant.

6. Composant selon l'une des revendications précédentes,
**caractérisé en ce que** le dispositif de blindage (3) comporte au niveau d'une de ses parois latérales une ouverture, appliquée, dans l'état du dispositif de blindage relié aux autres éléments du composant, sur une broche (41) agencée sur un des éléments du composant.

7. Composant selon la revendication 6,
**caractérisé en ce que** l'ouverture du dispositif de blindage (3) est constituée par un trou oblong s'étendant dans la direction verticale.

8. Composant selon l'une des revendications précédentes,
**caractérisé en ce que** le déplacement relatif entre le dispositif de blindage (3) et les éléments de raccordement électriques (2) est pour l'essentiel limité à des directions le long desquelles le dispositif de blindage peut être écarté des éléments de raccordement électriques lors du montage du composant sur la carte à circuit imprimé (LP), pour ne pas gêner le montage du composant.

9. Composant selon l'une des revendications précédentes,
**caractérisé en ce que** le déplacement relatif entre le dispositif de blindage (3) et les éléments de raccordement électriques (2) est pratiquement limité à la distance de laquelle le dispositif de blindage doit pouvoir être écarté des éléments de raccordement électriques lors du montage du composant sur la carte à circuit imprimé (LP), pour ne pas gêner le montage du composant.

10. Composant selon l'une des revendications précédentes,
**caractérisé en ce que** le dispositif de blindage (3) est constitué et/ou relié aux autres éléments du composants de sorte que les parties des éléments de raccordement électriques (2) devant être soudés sur la carte à circuit imprimé (LP) sont agencées, dans l'état de retenue du composant sur le dispositif de blindage, à un niveau plus bas que la partie du dispositif de blindage reposant sur la carte à circuit imprimé dans l'état du montage du composant sur la carte à circuit imprimé.

11. Composant selon l'une des revendications précédentes,
**caractérisé en ce que** le dispositif de blindage (3) est configuré et/ou relié aux autres éléments du composant de sorte que les parties des éléments de raccordement électriques (2) devant être soudées sur la carte à circuit imprimé (LP) se situent, dans un état de retenue du composant sur un autre élément différent du dispositif de blindage, à un niveau plus élevé que la partie du dispositif de blindage reposant sur la carte à circuit imprimé dans l'état de montage du composant sur la carte à circuit imprimé.

12. Composant selon l'une des revendications précédentes,
**caractérisé en ce que** le dispositif de blindage (3) est relié à la plaque à circuit imprimé (LP).
